# EUROPEAN PATENT APPLICATION

(11) **EP 4 560 343 A1**
(43) Date of publication of application: **28.05.2025**
(21) Application number: 24214034.1
(22) Date of filing: 19.11.2024
(51) Int. Cl.: G01R 35/00

(54) **MULTIPLE OUTPUT INSTRUMENT CALIBRATOR**

(30) Priority: 21.11.2023 US 202363601685 P
(71) Applicant: Fluke Corporation, Everett, WA 98203 (US)
(72) Inventor: HOLLINGWORTH, Simon T., Everett, 98203 (US)
(74) Representative: HGF

(57) **Abstract**

A calibration instrument includes a user interface for receiving an input of a waveform type, a waveform generator coupled to the user interface and structured to generate a calibration waveform based on the waveform type, and a plurality of output channels each structured to receive the calibration waveform and to generate a calibration signal independent from other output channels, each of the plurality of output channels including an output amplifier for generating the calibration signal having an output amplitude level and an active head structured to specify the output amplitude level of the calibration signal to its respective output amplifier. Methods of operation are also described.

## Description

### TECHNICAL FIELD

This disclosure relates to signal generation devices, and, more particularly, to a calibration instrument having a signal generator for calibrating oscilloscopes, the calibration instrument having multiple simultaneous outputs each of which may be independently configured.

### BACKGROUND

Oscilloscopes are test and measurement devices that measure input signals and generate an output display representing the tested signal. They are extremely sensitive instruments and can identify even slight variations in signals. To maintain accuracy, oscilloscopes are calibrated against known signals generated by a special class of signal generator known as a calibrator. A calibrator generates extremely high-quality signals, such as sine waves, square waves, pulses, linear ramps, and others, as well as time-invariant (Direct Current) signals having known parameters. These calibration signals having known parameters are fed to the input channels of an instrument, such as an oscilloscope, and the instrument calibrates itself using these high-quality calibration signals generated by the calibrator as reference signals.

Calibrating a multi-channel oscilloscope with a conventional calibration instrument takes significant time because calibration instruments are limited to calibrating only a single channel at any given time. To fully calibrate a multi-channel oscilloscope, each channel to be calibrated is calibrated sequentially while the channels not being calibrated remain idle and receive no calibration signals. Attempting to apply the same calibration signal simultaneously to several different channels would not allow individual sensing and control of the calibration signal at the input of each oscilloscope channel, which is particularly important if the channels present a 50 Ω input impedance. Mere splitting of the signal into all channels would result in differences in the signal levels at the inputs of the channels as well as an overall reduction of signal level.

Embodiments according to the disclosure address these and other limitations found in conventional calibrators.

### BRIEF DESCRIPTION OF THE DRAWINGS

Fig. 1 is a functional block diagram of a calibrator including multiple outputs according to the embodiments of the disclosure.
Fig. 2 is a schematic block diagram of an example control amplifier of the calibrator of Fig. 1, according to the embodiments of the disclosure.
Fig. 3 is a schematic block diagram of a head that couples between the control amplifier of Fig. 2 and an instrument input channel for calibration, according to the embodiments of the disclosure.
Fig. 4 is a block diagram illustrating a calibrator including multiple outputs according to the embodiments of the disclosure.

### SUMMARY

Embodiments according to the disclosure are directed to a calibration unit that simultaneously generates individually controllable calibration signals that may be coupled to input channels of one or more measurement instruments, such as oscilloscopes, so that multiple channels may be calibrated simultaneously. Advantageously, the architecture can simultaneously produce different amplitudes for different outputs because a head interposed between the instrument and the calibration device in each channel includes a combination of a controllable Digital to Analog Converter (DAC) and a switched attenuator to individually control one of the multiple control amplifiers in the calibration device. Thus, each output channel of the calibration device is individually controllable by individually controlling the DACs and/or switched attenuators in each head.

### DESCRIPTION

Presently, calibrating a multi-channel oscilloscope is a lengthy process as conventional calibration instruments produce only a single calibration signal at any given time. Full calibration therefore requires each channel of a multi-channel oscilloscope to be calibrated sequentially, one at a time, while the channels not being calibrated remain idle.

A new calibration instrument includes a signal splitter structured to provide a separate calibration signal to several channel amplifiers, or output amplifiers. Each channel amplifier in the calibration instrument is part of a signal path between the calibration instrument and an individual channel of the oscilloscope to be calibrated. Each signal path also includes a head unit, which is hardware that may be controlled to cause its associated channel amplifier to produce the calibration signal having the desired amplitude. Thus, each output channel of the calibration instrument is configurable to generate an individually selected calibration signal amplitude irrespective of the amplitudes of any other output channel of the calibrator.

Each channel includes an active head coupled between the instrument to be calibrated, such as an oscilloscope, and the control or channel amplifier for that channel in the calibration device. Together each active head and control amplifier create a control loop. Each head is individually programmable by the user to cause its respective control amplifier in the calibration instrument to generate the calibration signal having the amplitude specified by the user. Each pair of active heads and its control amplifier may operate independently of any other pair.

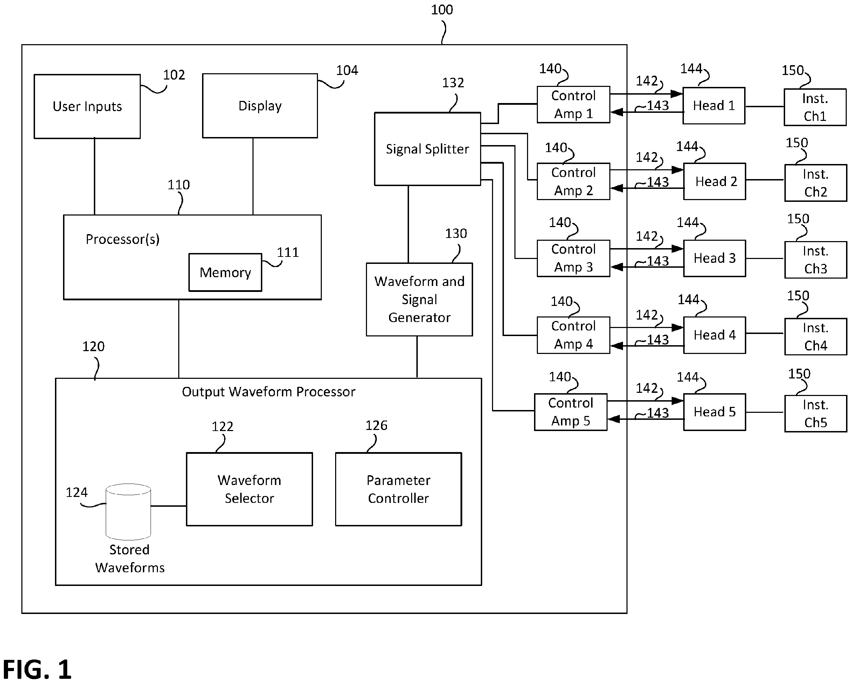

Embodiments of the disclosure operate on particular hardware and/or software to implement the above-described calibration system. Fig. 1 is a block diagram of an example calibrator 100 for simultaneously generating calibration signals at multiple outputs 142. The calibration signals may be different from one another. For example, as described below, individual outputs may be controlled to have an amplitude different than any other output. In this way, every calibration output signal of calibrator 100 may be controlled to have an amplitude that is set independently of any of the other outputs.

Calibrator 100 includes one or more processors 110 to operate the calibrator and generate the calibration signals. Although only one processor is shown in Fig. 1 for ease of illustration, as will be understood by one skilled in the art, multiple processors of varying types may be used in combination in calibrator 100, rather than a single processor. Processors 110 may be configured to execute instructions from memory 111 and may perform any methods and/or associated steps indicated by such instructions, such as generating specific and independently controlled calibration signals on multiple outputs simultaneously. Memory 111 may be implemented as processor cache, random access memory (RAM), read-only memory (ROM), solid state memory, hard disk drive(s), or any other memory type. Memory 111 may also be used as a medium for storing data, such as records of generated calibration signals, computer program products, and other instructions.

User inputs 102 are coupled to the processor 110. User inputs 102 may include a keyboard, mouse, touchscreen, and/or any other controls employable by a user to set up and operate the calibrator 100. User inputs 102 may include a graphical user interface or text/character interface operated in conjunction with a display 104. The user inputs 102 may receive remote commands or commands in a programmatic form, either on calibrator 100, or from a remote device. Display 104 presents operational menus and displays information about the calibrator 100 during operation. Display 104 may be a digital screen, a cathode ray tube-based display, or any other type of video monitor. While the components of the calibrator 100 are depicted as being integrated within the calibrator 100, it will be appreciated by a person of ordinary skill in the art that any of these components can be external to calibrator 100 and can be coupled to the calibrator in any conventional manner (e.g., wired and/or wireless communication media and/or mechanisms). For example, in some embodiments, display 104 may be remote from calibrator 100, or the calibrator may be configured to send output to a remote device in addition to displaying it on display 104 of calibrator 100.

Calibrator 100 may include an output waveform processor 120, which may be a separate processor from the processors 110 described above, or the functions of the output waveform processor 120 may be integrated into the processors 110. Additionally, the output waveform processor 120 may include separate memory, use memory 111 described above, or any other memory accessible by calibrator 100. The output waveform processor 120 may include specialized processors or operations to select the output calibration waveform type. As described above, the output waveform for calibration is generally a high-quality signal, such as a sine wave, square wave, a series of pulses, linear voltage ramps, or other type of signal. In addition, the output waveform may be a time-invariant DC signal having known parameters. When a user uses the user inputs 102 to select a particular output waveform type, a waveform selector 122 within the output waveform processor selects the desired waveform. Various waveforms may be stored in a file or database 124, for example. A parameter controller 126 allows the user to select parameters for the selected output waveform type. For example, a sine wave has frequency and amplitude, either or both of which may be selected by the user through the user inputs 102 on calibrator 100. Other parameters, such as a ramp rate or duty cycle of an output waveform having a series of pulses may also be selected by the user when other waveforms are used as the output waveform.

Any or all of the components of the output waveform processor 120, including the waveform selector 122 and parameter control 126 may be embodied in one or more separate processors, and the separate functionality described herein may be implemented as specific pre-programmed operations of a special purpose or general-purpose processor. Further, as stated above, any or all of the components or functionality of the output waveform processor 120 may be integrated into processors 110 that operate the calibrator 100.

Output from the output waveform processor drives a waveform generator, also referred to as a waveform and signal generator 130, which generates the base calibration signal or calibration waveform for the calibrator 100. This base calibration waveform is presented to a signal splitter 132, which divides and distributes the signal and passes it to a series of control amplifiers 140. There is one control amplifier 140 for each output channel of the calibrator 100. In the illustrated embodiment there are five output channels, and therefore there are five control amplifiers 140 present in the calibrator 100 of Fig. 1. The signal splitter 132 thus accepts the base calibration waveform from the waveform and signal generator 130 and presents it to each of the five control amplifiers 140. Of course, calibrator 100 may include any number of output channels, and five channels were selected only as an example number.

The signal path from the control amplifier 140 to an input channel of instrument 150 is the main path the calibration output waveform travels between the calibrator 100 and instrument 150. Each signal path includes a head 144 interposed between the control amplifier 140 and the instrument 150. Between each head 144 and its related or respective control amplifier 140 is a feedback loop created between each output 142 and a return path 143, which is described in detail below. The feedback loop created by each output 142 from each control amplifier 140 and a return path 143 from each head 144 allows each head to independently set the amplitude of the calibration output waveform.

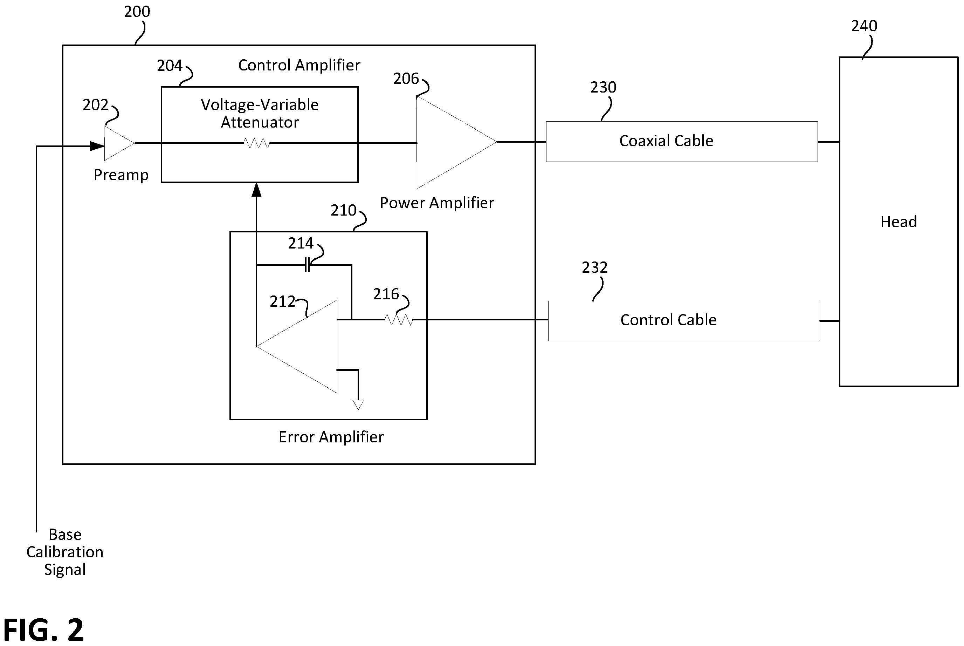

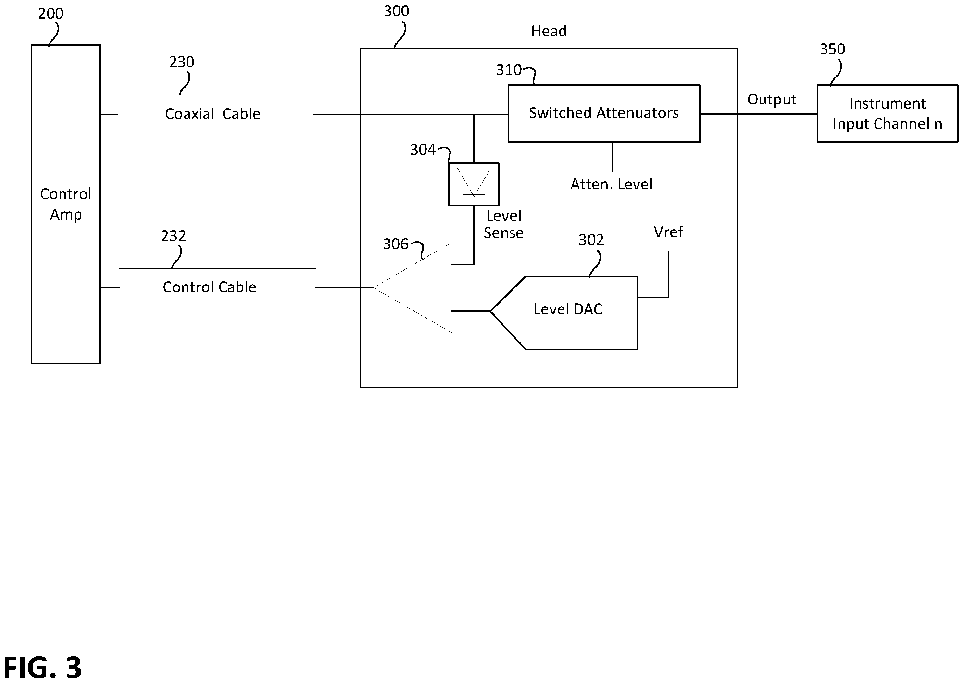

Fig. 2 illustrates a single, signal path that includes a control amplifier 200 coupled to a head 240, which may be an example embodiment of the head 144 of Fig. 1, through a pair of cables. The control amplifier 200 may be an example of the control amplifier 140 of Fig. 1, and may also be referred to as an output amplifier. One cable is a coaxial cable 230 that carries the calibration output waveform between the control amplifier and the head 240, while the other cable is a control cable 232 that carries signals between the head 240 and the control amplifier 200, as described with reference to Fig. 3. The combination of the coaxial cable 230 and the control cable 232 are an example of the feedback loop described with reference to Fig. 1, which runs between the control amplifier 140 and head 144. Recall that there may be many signal paths between the calibrator 100 (Fig. 1) and the instrument being calibrated, and Fig. 2 represents only a single of such paths.

Referring back to Fig. 2, the control amplifier accepts a base calibration signal, such as from the signal splitter 132 of Fig. 1. After running through a pre-amplifier 202, the base calibration signal passes through a voltage-variable attenuator 204 that is controlled by an error amplifier 210. The error amplifier 210 may include, in various embodiments, one or more of an operational amplifier 212, capacitor 214, and resistor 216. The error amplifier 210 receives its input from its respective head 240 through the control cable 232. In general, the head 240 creates a controllable signal that drives the error amplifier 210 to control the voltage-variable attenuator 204. The output of the voltage-variable attenuator 204 is sent to a power amplifier 206, which generates an amplified calibration signal before sending it through the coaxial cable 230 to the head 240.

Fig. 3 illustrates some of the same components as illustrated in Fig. 2, yet provides more detail of the components within a head 300. The head 300 of Fig. 3 may be an example of the head 144 of Fig. 1 and head 240 of Fig. 2. Fig. 3 shows additional detail of the signals that pass on the coaxial cable 230 and control cable 232. The head 300 includes a Digital to Analog Converter (DAC) 302. The DAC 302 is controllable, or programmable, to output a voltage having a controllable amplitude that is a multiple of a reference voltage, Vref. The level for the DAC 302 is set by a set of user interfaces, described below. The head 300 also includes a level sense circuit 304 that senses a voltage level of the amplified calibration signal that the control amplifier 200 placed on the coaxial cable 230. A comparison amplifier 306 accepts an output of the level sense circuit as well as from the DAC 302 and generates an error signal that it passes back through the control cable 232 to the control amplifier 200, and specifically to the error amplifier 210. The error amplifier 210 then generates an output based on this error signal to control the voltage-variable-attenuator 204. Using this feedback control loop between the control amplifier 200 and the head 300, a very stable calibration signal is produced. Then, a set of switched attenuators 310 may also modify the calibration signal before sending it through an output to a channel of an instrument 350 that is receiving the calibration signal. In particular, the level at which the switched attenuators 310 operate is provided or specified to the switched attenuators as an attenuation level. This level controls how much the switched attenuators 310 attenuate the calibration signal before sending it to an instrument 350. In total, then, by setting a value for DAC 302 and the attenuation level for the switched attenuators 310 in head 300, the combination of the control amplifier 200 and other components in head 300 set an amplitude for the calibration signal to be sent to the instrument 350 being calibrated. Recall that Figs. 2 and 3 illustrate only a single signal path between calibrator 100 and the multiple input channels of instrument 350, and that each of the signal paths carrying calibration signals to the instrument 350 may be individually set by setting the DAC value and attenuation level in each of the heads 300, such as the heads 144 in Fig. 1. The DAC value and attenuation level may be selected by the user using the user interface, or by another method. Further, the DAC value and attenuation level may be stored in a memory (not illustrated) within each head 300, so that they may be recalled or modified. By setting each of the DAC values and the attenuation levels in each of the heads 144 to different references and levels, the feedback loop between each control amplifier 200 and its respective head 300 produces a different amplitude of the calibration signal. Of course, not all of the heads 144 need to produce calibration signals having a unique amplitude, as many of the channels of the instrument may wish to receive the same magnitude calibration signal. Embodiments according to the disclosure, however, provide such flexibility that any of the input channels may have any desired amplitude, regardless of the amplitude of any other input channel.

In some embodiments, the DAC 302 may be located in the control amplifier 200 instead of being located in the head 300. The general principles of operation would be the same as described above, with the control amplifier 200 generating the calibration waveform at the desired amplitude no matter if the DAC 302 is located in the control amplifier 200 or the head 300.

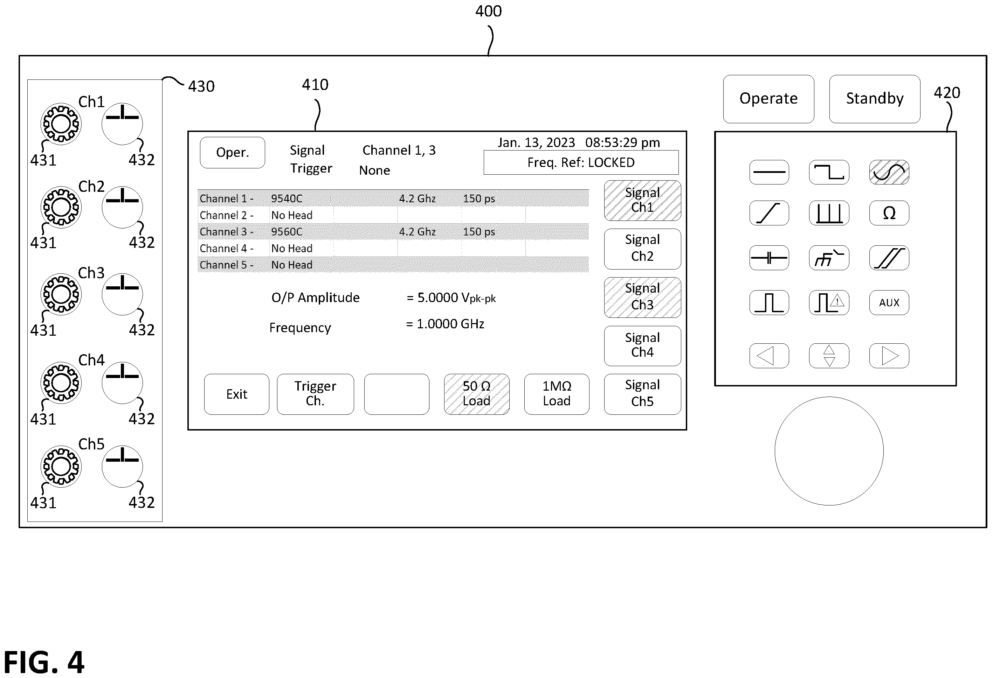

Fig. 4 is a block diagram illustrating a calibrator 400 including multiple outputs according to embodiments of the disclosure. The calibrator 400 of Fig. 4 may be an example of the calibrator 100 of Fig. 1. In general, the calibrator 400 includes a user interface display or user interface 410, user inputs 420, and outputs 430. In the outputs 430, there are five pairs of connectors for the five output channels, Chl - Ch5. The connection for each channel being used includes a coaxial connector 431 for the coaxial cable 230 and a control connector 432 for the control cable 232 described above. In general, for each channel being used, one end of the coaxial cable 230 (Fig. 2) would be connected directly to coaxial connector 431 on calibrator 400, and the other end coupled to a respective head. Likewise, for each channel being used, one end of control cable 232 (Fig. 2) would be connected directly to the control connector 432 on calibrator 400. Then there would be a further connection between the head and an input channel of the instrument, as illustrated in Fig. 1. The control amplifier 200 (Fig. 2) and its components are located within the calibrator 400, and is coupled to the channel connectors from the inside of the calibrator.

The user inputs 420 allow the user to select which base signal type will be used as the calibration signal. Example calibration signals include, for example, a Direct Current (DC) signal, square waves, sinewaves, timing markers, pulses, rising or falling edges, or use a signal from an auxiliary source. The user interface 410 allows the user to set parameters of the selected calibration signal, such as frequency, amplitude, and pulse ramp times, for example. Embodiments of the disclosure allow the calibration waveform type and parameters to be individually set for each channel, or groups of channels simultaneously. In the illustrated example only Channels 1 and 3 are selected to produce a sinewave type of calibration signal, and both have an amplitude of 5 Volts peak-to-peak at a frequency of 1.0 GHz. The selected parameters are illustrated on the user interface 410 during the setup and operation of the calibrator 400. Thus, it is not necessary that every channel of the instrument is calibrated during every calibration; instead, particular channels of the instrument may be selected, or not selected, for calibration.

In operation, a user interacts with the user inputs 420 to select the particular calibration waveform and amplitude for each channel that will be operating. The configuration details of the settings of the calibrator 400 are shown on the user interface 410, where the user can verify the calibrator is properly configured. Then the user presses an "operate" button or selects the equivalent in a user menu which causes the calibrator 400 to generate the calibration signals for the connected instrument.

Aspects of the disclosure may operate on particularly created hardware, firmware, digital signal processors, or on a specially programmed general-purpose computer including a processor operating according to programmed instructions. The terms controller or processor as used herein are intended to include microprocessors, microcomputers, Application Specific Integrated Circuits (ASICs), and dedicated hardware controllers. One or more aspects of the disclosure may be embodied in computer-usable data and computer-executable instructions, such as in one or more program modules, executed by one or more computers (including monitoring modules), or other devices. Generally, program modules include routines, programs, objects, components, data structures, etc. that perform particular tasks or implement particular abstract data types when executed by a processor in a computer or other device. The computer executable instructions may be stored on a non-transitory computer-readable medium such as a hard disk, optical disk, removable storage media, solid state memory, Random Access Memory (RAM), etc. As will be appreciated by one of skill in the art, the functionality of the program modules may be combined or distributed as desired in various aspects. In addition, the functionality may be embodied in whole or in part in firmware or hardware equivalents such as integrated circuits, Field Programmable Gate Arrays (FPGAs), and the like. Particular data structures may be used to more effectively implement one or more aspects of the disclosure, and such data structures are contemplated within the scope of computer-executable instructions and computer-usable data described herein.

The disclosed aspects may be implemented, in some cases, in hardware, firmware, software, or any combination thereof. The disclosed aspects may also be implemented as instructions carried by or stored on one or more non-transitory computer-readable media, which may be read and executed by one or more processors. Such instructions may be referred to as a computer program product. Computer-readable media, as discussed herein, means any media that can be accessed by a computing device. By way of example, and not limitation, computer-readable media may comprise computer storage media and communication media.

Computer storage media means any medium that can be used to store computer-readable information. By way of example, and not limitation, computer storage media may include RAM, ROM, Electrically Erasable Programmable Read-Only Memory (EEPROM), flash memory or other memory technology, Compact Disc Read Only Memory (CD-ROM), Digital Video Disc (DVD), or other optical disk storage, magnetic cassettes, magnetic tape, magnetic disk storage or other magnetic storage devices, and any other volatile or nonvolatile, removable or non-removable media implemented in any technology. Computer storage media excludes signals per se and transitory forms of signal transmission.

Communication media means any media that can be used for the communication of computer-readable information. By way of example, and not limitation, communication media may include coaxial cables, fiber-optic cables, air, or any other media suitable for the communication of electrical, optical, Radio Frequency (RF), infrared, acoustic or other types of signals.

### EXAMPLES

Illustrative examples of the disclosed technologies are provided below. An embodiment of the technologies may include one or more, and any combination of, the examples described below.

Example 1 is a calibration instrument, including a user interface for receiving an input of a waveform type, a waveform generator coupled to the user interface and structured to generate a calibration waveform based on the waveform type, and a plurality of output channels each structured to receive the calibration waveform and to generate a calibration signal independent from other output channels, each of the plurality of output channels including an output amplifier for generating the calibration signal having an output amplitude level and an active head structured to specify the output amplitude level of the calibration signal to its respective output amplifier.

Example 2 is a calibration instrument according to Example 1, or any other Example herein, in which the user interface is configured to accept a frequency parameter, and in which the waveform generator is structured to generate the calibration signal based on the waveform type and the frequency parameter.

Example 3 is a calibration instrument according to any of the preceding Examples, or any other Example herein, in which the user interface is configured to respectively receive the output amplitude levels for two or more of the plurality of output channels.

Example 4 is a calibration instrument according to Example 3, or any other Example herein, in which the calibration instrument is structured to respectively communicate the output amplitude levels to their respective active heads in respective output channels of the two or more of the plurality of output channels.

Example 5 is a calibration instrument according to any of the preceding Examples, or any other Example herein, in which the output amplitude level is set by an output of a digital to analog converter in the active head.

Example 6 is a calibration instrument according to Example 5, or any other Example herein, in which at least two respective outputs of respective digital to analog converters are set to different values.

Example 7 is a calibration instrument according to any of the preceding Examples, or any other Example herein, in which the active head includes a set of switched attenuators, and the active head is structured to receive an attenuation level.

Example 8 is a calibration instrument according to any of the preceding Examples, or any other Example herein, further including a splitter configured to distribute the calibration waveform to the output amplifier of each of the plurality of output channels.

Example 9 is a calibration instrument, including a calibration signal generator, a splitter coupled to the calibration signal generator and configured to generate a plurality of calibration signals, and a plurality of calibration output paths, each path including a channel amplifier for receiving one of the plurality of calibration signals from the splitter and generating an amplified calibration signal having an output amplitude level, and an active head structured to specify the output amplitude level of the amplified calibration signal to the channel amplifier.

Example 10 is a calibration instrument according to Example 9, or any other Example herein, in which each of the plurality of calibration output paths is configured to receive an independently specified output amplitude level.

Example 11 is a calibration instrument according to any of the preceding Examples 9 - 10, or any other Example herein, in which the active head includes a digital to analog converter that is used to control the output amplitude level.

Example 12 is a calibration instrument according to any of the preceding Examples 9 - 11, or any other Example herein, in which the active head includes a set of switched attenuators structured to control the output amplitude level.

Example 13 is a calibration instrument according to Example 12, or any other Example herein, in which the set of switched attenuators is configured to be set independently from other sets of switched attenuators in other calibration output paths.

Example 14 is a calibration instrument according to any of the preceding Examples 9 - 13, or any other Example herein, further including a user interface structured to respectively accept the amplitude levels for the plurality of calibration output paths, and in which the calibration instrument is configured to set respective output amplitude levels in respective active heads of the plurality of calibration output paths according to the accepted amplitude levels.

Example 15 is a method for generating two or more calibration signals simultaneously in a calibration device, the method including generating a base calibration signal, simultaneously routing the base calibration signal to two or more output paths of the calibration device, and generating, in each of the two or more output paths, an output calibration signal having an individually controllable amplitude.

Example 16 is a method according to Example method 15, in which the individually controllable amplitude in each of the two or more output paths is controllable by a user through a user interface.

Example 17 is a method according to any of the preceding Example methods 15 - 16, in which generating an output calibration signal having an individually controllable amplitude comprises setting a digital to analog converter in each of the two or more output paths.

Example 18 is a method according to any of the preceding Example methods 15 - 17, in which generating an output calibration signal having an individually controllable amplitude comprises specifying an attenuation level to a set of switched attenuators in each of the two or more output paths.

Example 19 is a method according to any of the preceding Example methods 15-18, further comprising, in each of the two or more output paths, creating a feedback loop between an amplifier and a head, in which the individually controllable amplitude is set by setting a parameter in the head.

Example 20 is a method according to any of the preceding Example methods 15-19, further comprising accepting a calibration waveform type and a frequency, and in which generating a base calibration signal includes generating a base calibration signal based on the calibration waveform type and the frequency.

The previously described versions of the disclosed subject matter have many advantages that were either described or would be apparent to a person of ordinary skill. Even so, these advantages or features are not required in all versions of the disclosed apparatus, systems, or methods.

Additionally, this written description makes reference to particular features. It is to be understood that the disclosure in this specification includes all possible combinations of those particular features. Where a particular feature is disclosed in the context of a particular aspect or example, that feature can also be used, to the extent possible, in the context of other aspects and examples.

Also, when reference is made in this application to a method having two or more defined steps or operations, the defined steps or operations can be carried out in any order or simultaneously, unless the context excludes those possibilities.

Although specific examples of the invention have been illustrated and described for purposes of illustration, it will be understood that various modifications may be made without departing from the spirit and scope of the invention. Accordingly, the invention should not be limited except as by the appended claims.

## Claims

1. A calibration instrument, comprising:
a user interface structured to receive an input of a waveform type;
a waveform generator coupled to the user interface and structured to generate a calibration waveform based on the waveform type; and
a plurality of output channels each structured to receive the calibration waveform and to generate a calibration signal independent from other output channels, each of the plurality of output channels including an output amplifier operable to generate the calibration signal having an output amplitude level, and an active head structured to specify the output amplitude level of the calibration signal to its respective output amplifier.

2. The calibration instrument according to claim 1, in which the user interface is configured to accept a frequency parameter, and in which the waveform generator is structured to generate the calibration signal based on the waveform type and the frequency parameter.

3. The calibration instrument according to claim 1 or 2, in which the user interface is configured to respectively receive the output amplitude levels for two or more of the plurality of output channels.

4. The calibration instrument according to claim 3, in which the calibration instrument is structured to respectively communicate the output amplitude levels to their respective active heads in respective output channels of the two or more of the plurality of output channels.

5. The calibration instrument according to any of claims 1 to 4, in which the output amplitude level is set by an output of a digital to analog converter in the active head.

6. The calibration instrument according to claim 5, in which at least two respective outputs of respective digital to analog converters are set to different values.

7. The calibration instrument according to any of claims 1 to 6, in which the active head includes a set of switched attenuators, and the active head is structured to receive an attenuation level.

8. The calibration instrument according to any of claims 1 to 7, further comprising:
a splitter configured to distribute the calibration waveform to the output amplifier of each of the plurality of output channels.

9. The calibration instrument according to claim 7 or 8, in which the set of switched attenuators is configured to be set independently from other sets of switched attenuators in other calibration output paths.

10. A method for generating two or more calibration signals simultaneously in a calibration device, the method comprising:
generating a base calibration signal;
simultaneously routing the base calibration signal to two or more output paths of the calibration device; and
generating, in each of the two or more output paths, an output calibration signal having an individually controllable amplitude.

11. The method according to claim 10, in which the individually controllable amplitude in each of the two or more output paths is controllable by a user through a user interface.

12. The method according to claim 10 or 11, in which generating an output calibration signal having an individually controllable amplitude comprises setting a digital to analog converter in each of the two or more output paths.

13. The method according to any of claims 10 to 12, in which generating an output calibration signal having an individually controllable amplitude comprises specifying an attenuation level to a set of switched attenuators in each of the two or more output paths.

14. The method according to any of claims 10 to 13, further comprising, in each of the two or more output paths, creating a feedback loop between an amplifier and a head, in which the individually controllable amplitude is set by setting a parameter in the head.

15. The method according to any of claims 10 to 14, further comprising accepting a calibration waveform type and a frequency, and in which generating a base calibration signal includes generating a base calibration signal based on the calibration waveform type and the frequency.
